Europäisches Patentamt

European Patent Office

Office européen des brevets

(19)

(11) **EP 1 359 694 A2**

(12) **EUROPÄISCHE PATENTANMELDUNG**

(43) Veröffentlichungstag:
    **05.11.2003  Patentblatt 2003/45**

(51) Int Cl.$^7$: **H04L 1/00**

(21) Anmeldenummer: **03008138.4**

(22) Anmeldetag: **08.04.2003**

(84) Benannte Vertragsstaaten:
    **AT BE BG CH CY CZ DE DK EE ES FI FR GB GR HU IE IT LI LU MC NL PT RO SE SI SK TR**
    Benannte Erstreckungsstaaten:
    **AL LT LV MK**

(30) Priorität: **02.05.2002  DE 10219700**

(71) Anmelder: **Astrium GmbH**
    **81663 München (DE)**

(72) Erfinder: **Trautenberg, Hans L., Dr.**
    **92318 Neumarkt (DE)**

(74) Vertreter: **Ulrich, Thomas**
    **EADS Deutschland GmbH**
    **Patentabteilung**
    **LG-SP**
    **81663 München (DE)**

(54) **Verfahren zum Interleaving von Daten und Teilnehmer-Endgerät**

(57)    Beschrieben wird ein Verfahren zur Bereitstellung und Übertragung von Daten in einem Datenübertragungssystem durch Übertragung von mehreren Datenblocks von einer Daten-Sendeeinrichtung an Endgeräte. Vor der Übertragung der Daten an die Endgeräte erfolgt ein Interleaving von mindestens zwei Datenblocks. Zum Interleaving wird für jede Dateneinheit der Datenblocks mit Hilfe eines Algorithmus ein Sendezeitpunkt derart festgelegt, dass zur Übertragung von k zeitkritischen Datenblocks mit k= 2, 3, 4, ... und eines zeitunkritischen Datenblocks die Sendezeitpunkte der Dateneinheiten eines jeden zeitkritischen Datenblocks jeweils in einem Bruchteil 1/k der Sendezeit des zeitunkritischen Datenblocks festgelegt werden.

Fig. 1

EP 1 359 694 A2

**Beschreibung**

Die vorliegende Erfindung betrifft ein Verfahren zur Bereitstellung und Übertragung von Daten in einem Datenübertragungssystem durch Übertragung von mehreren Datenblocks von einer Daten-Sendeeinrichtung an Endgeräte, wobei vor der Übertragung der Daten an die Endgeräte ein Interleaving von mindestens zwei Datenblocks erfolgt.

Aus dem Stand der Technik sind grundsätzlich Verfahren zum Interleaving von Daten bekannt. US 5,557,608 A beschreibt ein Verfahren zur Übertragung von höherprioem, z. B. realtime Datenverkehr über niederpriore, z.B. nonrealtime Datenverbindungen durch Einfügen entsprechender Datenblöcke. Aus JP 8-214028 A ist ein blockweises Interleaving-Verfahren bekannt, bei dem zur Fehlerüberprüfungskodierung ein Datenpaket, welches als n-faches Matrixpaket unterteilt wird, in kleine Blöcke aufgeteilt wird und Korrekturcodes eingefügt werden, wobei nachfolgend ein Interleaving der Blöcke erfolgt. Aus US 6,337,642 B1 ist ein Verfahren zum Interleaving für variable Paketlängen bekannt, wobei eine opimale Blockgröße abhängig von einer vorgewählten Paketlänge und Interleaver-Weite ermittelt wird.

Aufgabe der vorliegenden Erfindung ist es jedoch, eine Möglichkeit bereitzustellen, die eine Optimierung eines Interleaving-Prozesses erlaubt, welche berücksichtigt, dass Datenblocks unterschiedlicher Relevanz vorliegen können.

Diese Aufgabe wird gelöst durch die Merkmale des Anspruchs 1. Weiterer Gegenstand der vorliegenden Erfindung ist ein Teilnehmer-Endgerät nach Anspruch 9. Die Erfindung ist grundsätzlich für alle Arten von Datenübertragungssystemen anwendbar, insbesondere für Kommunikationssysteme, beispielsweise drahtlose Kommunikationssysteme.

Ein erster Gegenstand der Erfindung ist ein Verfahren zur Bereitstellung und Übertragung von Daten in einem Datenübertragungssystem durch Übertragung von mehreren Datenblocks von einer Daten-Sendeeinrichtung an Endgeräte, wobei vor der Übertragung der Daten an die Endgeräte ein Interleaving von mindestens zwei Datenblocks erfolgt. Als Interleaving wird hier grundsätzlich jede Art der Aufteilung und Neugruppierung der Daten der einzelnen Datenblocks verstanden, wobei Daten unterschiedlicher Datenblocks zu einem neuen Datenpacket zusammengefügt werden. Der Vorteil des Interleaving ist, dass die Daten eines Datenblocks auf mehrere Datenpakete verteilt werden können und so die einzelnen Daten des Datenblocks bei einer Datenübertragung separiert werden können. Wird bei einer Datenübertragung ein Datenpaket fehlerhaft übertragen, so gehen nicht alle Daten eines Datenblocks verloren, sondern nur ein Teil des Datenblocks. Der verloren gegangene Teil kann dann eventuell aus den übrigen Daten des Datenblocks, die in anderen Datenpaketen übertragen wurden, rekonstruiert werden.

Es kann lediglich eine Daten-Sendeeinrichtung des Datenübertragungssystems ein hier beschriebenes erfindungsgemäßes Verfahren durchführen oder es können auch mehrere oder alle Daten-Sendeeinrichtungen des Datenübertragungssystems ein solches Verfahren durchführen und auch entsprechend ausgebildet sein.

Der Umfang der Daten, über die ein Interleaving durchgeführt wird, kann durch den Dateninhalt eines Datenrahmens (Frame) definiert werden, der letztlich an die Endgeräte übertragen wird. Ein solcher Datenrahmen ist in der Regel zumindest definiert durch Signalisierungsdaten (Header) und Nutzdaten, wobei die Signalisierungsdaten zumindest Identifizierungsdaten zur Identifizierung des Datenrahmens enthalten. Der Umfang der Daten, über die ein Interleaving durchgeführt wird, kann aber auch durch eine vorgegebene Sendezeit für einen der Datenblocks festgelegt werden. Eine typische Sendezeit in Satelliten-Datenübertragungssystemen für Datenblocks, die Nutzdaten enthalten, ist beispielsweise eine Sekunde.

Zum Interleaving kann insbesondere für jede Dateneinheit der Datenblocks mit Hilfe eines Algorithmus ein Sendezeitpunkt festgelegt werden, wobei die Abfolge der Sendezeitpunkte von der ursprünglichen Abfolge der Dateneinheiten innerhalb der Datenblocks abweicht. Es wird damit also eine Aussendung der einzelnen Dateneinheiten der Datenblocks bewirkt, in der die Abfolge der Dateneinheiten nicht mehr der ursprünglichen Abfolge der Dateneinheiten in den Datenblocks entspricht. Die Bedeutung der Dateneinheiten wird im folgenden noch definiert.

Die vorliegende Erfindung betrachtet speziell den Fall, dass in der gleichen Zeit, in der ein zeitunkritischer Datenblock gesendet werden soll, auch k zeitkritische Datenblocks gesendet werden sollen mit k= 2, 3, 4..., so kann der Algorithmus derart ausgebildet sein, dass zur Übertragung der k zeitkritischen Datenblocks mit k= 2, 3, 4, ... und des einen zeitunkritischen Datenblocks die Sendezeitpunkte der Dateneinheiten eines jeden zeitkritischen Datenblocks jeweils in einem Bruchteil 1/k der Sendezeit des zeitunkritischen Datenblocks festgelegt werden. Ist beispielsweise eine Sendezeit von einer Sekunde für einen zeitunkritischen Datenblock vorgesehen und sollen in der gleichen Zeit 2 zeitkritische Datenblocks gesendet werden, so ist der Algorithmus derart ausgebildet, dass die erste zeitkritische Nachricht in der ersten Hälfte der Sendezeit, also in der ersten ½-Sekunde gesendet und die zweite zeitkritische Nachricht in der zweiten Hälfte der Sendezeit, also in der zweiten ½-Sekunde gesendet. Die Bedeutung von zeitkritischen und zeitunkritischen Datenblocks wird im folgenden noch definiert.

Ein Vorteil dieser Weiterbildung ist, dass die zeitkritischen Datenblocks bereits in einem Bruchteil 1/k der Sendezeit des zeitunkritischen Datenblocks komplett empfangen und im Endgerät verarbeitet werden können. Auch kann eine schnellere Aussendung der zeitkritischen Datenblocks erfolgen, da bereits nach dem vorliegen des ersten zeitkritischen Datenblocks mit der Aussendung der Daten begonnen werden kann, denn der zweite zeitkritischen Datenblock muss erst in dem zweiten Bruchteil 1/k der Sendezeit zur Aussendung vorliegen. Analoges gilt für weitere zeitkritischen Datenblocks.

Zur Durchführung des Interleaving können die Datenblocks in gleiche Pakete mit indizierten Datenadressen aufgeteilt werden. Ein Interleaving kann dann durch aufeinanderfolgende Übertragung jeweils einer Dateneinheit eines Paketes erfolgen. Es wird also beispielsweise nach der Aufteilung der Daten der Datenblocks auf die Pakete eine beliebige erste Dateneinheit des ersten Pakets gesendet, dann eine beliebige erste Dateneinheit des zweiten Pakets, dann eine beliebige erste Dateneinheit des dritten Pakets usw. bis zum letzten Paket. Dann wird eine zweite Dateneinheit des ersten Pakets gesendet, dann eine zweite Dateneinheit des zweiten Pakets usw. bis zum letzten Paket. Dieses Verfahren wird bis zur letzten Dateneinheit eines jeden Pakets fortgesetzt.

Im vorgenannten Beispiel wird von einer beliebigen Reihenfolge der Aussendung der Dateneinheiten pro Paket ausgegangen. Es kann aber auch eine Aussendung der Dateneinheiten pro Paket entsprechend der Indizierung der Datenadressen des Pakets erfolgen. So kann vorgesehen werden, dass zunächst nacheinander die Dateneinheiten aller Pakete mit der niedrigsten oder höchsten Datenadresse gesendet werden und dann die nacheinander die Dateneinheiten aller Pakete mit der nächsthöheren oder nächstniedrigeren Datenadresse gesendet werden. Stellt man die Pakete in Form von Spalten nebeneinander dar, so dass die Gesamtheit der Pakete eine Matrix bildet, dann entspricht diese Art der Aussendung einer zeilenweisen Aussendung der Dateneinheiten der Pakete.

Indizierte Datenadressen bedeutet dabei, dass korrespondierende Datenadressen der einzelnen Datenpakete für das Datenübertragungssystem über die Adressen erkennbar sind, d. h. dass insbesondere Anfang und Ende der Datenpakete ermittelbar sind und dass eine Reihenfolge der Daten innerhalb der Datenpakete definiert ist. Die Art der Indizierung und Adressierung kann grundsätzlich frei in geeigneter Weise gewählt werden.

Eine Weiterbildung der Erfindung sieht vor, dass mindestens eine erste Gruppe von Paketen für Datenblocks mit zeitkritischen Daten reserviert wird und mindestens eine zweite Gruppe von Paketen für Datenblocks mit zeitunkritischen Daten reserviert wird. Es werden also nicht alle Arten von Daten gleichermaßen auf Datenpakete aufgeteilt, sondern es wird dabei nach der Bedeutung der Daten, speziell nach zeitkritischen Aspekten, unterschieden. Damit wird ein unterschiedliche Behandlung von zeitkritischen und zeitunkritischen Daten im Rahmen des Interleaving möglich, die Vorteile für die Weiterverarbeitung von Daten bietet, wie im weiteren noch ausgeführt wird. Als zeitkritische Daten sind solche Daten zu verstehen, die einen sicheren Betrieb oder für bestimmte Anwendungen in den Endgeräten möglichst umgehend an die Endgeräte übertragen werden müssen. Typische Zeiträume sind hier unter einer Sekunde. Zeitunkritische Daten sind dagegen Daten, die das Endgerät zwar für den Betrieb oder bestimmte Anwendungen benötigt, die aber auch mit einer gewissen Verzögerung beim Endgerät ankommen können, ohne dass der Betrieb des Endgerätes wesentlich gestört wird. Das Verhältnis der Zahlen der Pakete, die für zeitkritische und zeitunkritische Daten reserviert werden, wird bevorzugt bestimmt durch das Verhältnis der Datenmengen der zeitkritischen Daten und zeitunkritischen Daten. Beträgt die Datenmenge der zeitkritischen Daten ein Viertel bzw. die Hälfte der Datenmenge der zeitunkritischen Daten, so wird ein Viertel bzw. die Hälfte der Pakete für die zeitkritischen Daten reserviert, der Rest für die zeitunkritischen Daten.

Insbesondere kann vorgesehen werden, dass als zeitkritische Daten Statusnachrichten oder Signalisierungsdaten übertragen werden und als zeitunkritische Daten Nutzdaten übertragen werden, wobei die Nutzdaten unmittelbar für den Teilnehmer-Betrieb der Endgeräte verwendet werden. Als Statusinformationen können beispielsweise Identifikationsdaten von Systemkomponenten, Versionsdaten von bestimmter Software auch sonstige Arten von Statusinformationen übertragen werden, also Signalisierungsdaten können alle Arten von Signalisierung übertragen werden, die für die Steuerung des Datenaustausches zwischen Daten-Sendeeinrichtung und Endgerät erforderlich oder hilfreich ist.

Bei einem speziellen Verfahren des Interleavings von zeitkritischen und zeitunkritischen Daten wird vorgesehen, dass

- alle Pakete eine Länge von n Dateneinheiten aufweisen,
- Pakete der ersten Gruppe von Paketen mit n/k, k=2, 3, 4, 5... Dateneinheiten eines Datenblocks zeitkritischer Daten gefüllt werden und
- Pakete der zweiten Gruppe von Paketen mit n Dateneinheiten eines Datenblocks zeitunkritischer Daten gefüllt werden.

Alle Datenpakete besitzen also die gleiche Länge. Als Dateneinheit kann beispielsweise ein Bit, ein Byte oder ein sonstiges, definiertes Datensymbol mit definierter Symbollänge vorgesehen werden. Die Pakete der zweiten Gruppe werden einfach mit den zeitunkritischen Daten der entsprechenden Datenblocks komplett aufgefüllt. Ist das Ende eines Datenblocks mit zeitunkritischen Daten erreicht, so wird das Auffüllen der Pakete, welche für zeitunkritische Daten reserviert sind, mit dem nächsten Datenblock zeitunkritischer Daten fortgesetzt.

Zeitkritische Daten werden jedoch anders behandelt: Es werden die für zeitkritische Daten reservierten Pakete nicht bis zur vollen Länge n mit den Daten zeitkritischer Datenblocks gefüllt, sondern es werden nur n/k Dateneinheiten eines Pakets mit Daten eines bestimmten Datenblocks gefüllt, im einfachsten Fall nur die erste Hälfte des Pakets. Der Dateninhalt des Datenblocks mit zeitkritischen Daten wird damit auf jeweils die erste Hälfte mehrerer Pakete verteilt. Dies bedeutet aber einen besonderen Vorteil: Durch das Interleaving werden die Dateninhalte der Pakete so übertragen, dass zunächst nacheinander alle Dateneinheiten übertragen werden, die am Anfang der Pakete stehen. Danach werden nacheinander alle Dateneinheiten übertragen, die an zweiter Stelle der Pakete stehen. Dies wird fortgeführt, bis das Ende der Pakete erreicht ist. Man kann leicht erkennen, dass ein Datenblock, der jeweils auf die erste Hälfte mehrerer Pakete aufgeteilt wurde, bereits nach der Hälfte der Zeit, die zur Übertragung aller Daten aller Pakete erforderlich ist, komplett übertragen wurde. Gleiches gilt für den allgemeinen Fall von n/k Dateneinheiten mit k=2, 3, 4.... Durch dieses Verfahren können also zeitkritische Daten sehr schnell komplett übertragen werde und trotzdem einem Interleaving unterzogen werden. Die ganze Zahl k kann grundsätzlich frei definiert werden. Sie entspricht aber bevorzugt der Zahl an Datenblocks mit zeitkritischen Daten, die in einer bestimmten Zeiteinheit übertragen werden müssen.

Bevorzugt wird vorgesehen, dass die Datenmenge der zeitkritischen Daten maximal die Hälfte, idealerweise maximal ein Viertel der Datenmenge der zeitunkritischen Daten beträgt. Damit wird die Effektivität des Verfahrens sichergestellt.

Die Daten-Sendeeinrichtungen des Datenübertragungssystem weisen sinnvollerweise Einrichtungen zur Bereitstellung von Daten in Form von mehreren Datenblocks und andererseits Einrichtungen zur Übertragung von Daten an Endgeräte auf, wobei jede Daten-Sendeeinrichtungen entsprechend der vorliegenden Erfindung eine Einrichtung zum Interleaving von mindestens zwei Datenblocks nach einem erfindungsgemäßen Verfahren vor der Übertragung der Daten an die Endgeräte aufweist. Die Einrichtung zum Interleaving kann insbesondere so weiter ausgebildet sein, dass sie zur Durchführung einzelner oder aller Schritte eines Interleaving-Verfahrens geeignet ist, wie es vorstehend beschrieben wurde. Die Einrichtung zum Interleaving ist dann an die entsprechenden Schritte des Interleaving-Verfahrens geeignet angepasst.

Ein weiterer Gegenstand der vorliegenden Erfindung ist ein Teilnehmer-Endgerät für ein Datenübertragungssystem. Gemäß der Erfindung weist das Teilnehmer-Endgerät eine Einrichtung zur Rekonstruktion von Datenblocks auf, welche vom Teilnehmer-Endgerät durch eine Empfangseinrichtung von mindestens einer Daten-Sendeeinrichtungen empfangen wurden und welche vor dem Empfang einem Interleaving nach einem vorstehend beschriebenen Verfahren unterzogen wurden. Die entsprechende Einrichtung des Teilnehmer-Endgerätes ist also dazu ausgebildet, die Daten in der oben beschriebenen Form zu erkennen und aus diesen durch ein dem Interleaving komplementäres De-Interleaving wieder die ursprünglichen Datenblocks zu rekonstruieren.

Eine Weiterbildung des vorliegenden Teilnehmer-Endgerätes beinhaltet ein Computer-Programm zur Verarbeitung von Daten eines Datenübertragungssystems, welche nach einem vorstehend beschriebenen Verfahren einem Interleaving unterzogen wurden, wobei das Computer-Programm für ein Zusammenwirken mit Einrichtungen eines vorgenannten Teilnehmer-Endgerätes ausgebildet ist. Das Computer-Programm erkennt und verarbeitet also die Daten in der oben beschriebenen Form und ist in der Lage, durch ein dem Interleaving komplementäres De-Interleaving wieder die ursprünglichen Datenblocks zu rekonstruieren.

Eine weitere Weiterbildung des vorliegenden Teilnehmer-Endgerätes beinhaltet ein Computer-Programm-Produkt beinhaltend einen maschinenlesbaren Programmträger, auf dem ein vorgenanntes Computer-Programm in Form von elektronisch auslesbaren Steuersignalen gespeichert ist, wobei das Computer-Programm-Produkt zum Zusammenwirken mit einem Teilnehmer-Endgerät ausgebildet ist. Die Steuersignale können in jeder geeigneten Form gespeichert sein, die elektronische Auslesung kann dann entsprechend durch elektrische, magnetische, elektromagnetische, elektrooptische oder sonstige elektronische Verfahren erfolgen. Beispiele für solche Programmträger sind Magnetbänder, Disketten, Festplatten, CD-ROM oder Halbleiterbausteine.

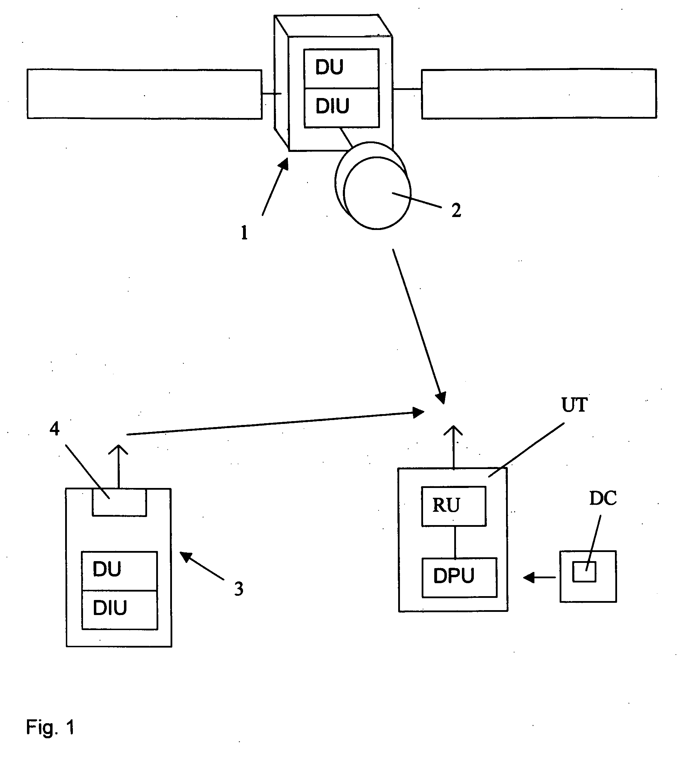

Nachfolgend wird ein spezielles Ausführungsbeispiel anhand der Figur 1 und der Tabellen 1 und 2 erläutert.

Es zeigt:

**Fig. 1:**        Schematische Darstellung eines Datenübertragungssystems

**Tab. 1 und 2:**    Schematische Darstellung der Aufteilung von Datenblocks auf Datenpakete

In Fig. 1 ist schematisch ein Datenübertragungssystem dargestellt. Eine Daten-Sendeeinrichtungen, beispielsweise ein Datenübertragungs-Satellit 1 oder eine erdgebundene Daten-Sendeeinrichtungen 3, weist eine Einrichtung DU (Data Unit) zur Bereitstellung von Datenblocks auf. Es sollen hier zwei Arten von Datenblocks betrachtet werden: Nutzdaten und Signalisierungsdaten. Dies wird anhand der Tabellen detaillierter erläutert. Jede Daten-Sendeeinrichtung 1, 3 weist weiter eine Einrichtung DIU (Data Interleaving Unit) zum Interleaving von Datenblocks auf. Dieses Interleaving der Datenblocks erfolgt, bevor eine Übertragung der Daten an ein Teilnehmer-Endgerät UT (User Terminal) erfolgt. Zur Übertragung der Daten weist die Daten-Sendeeinrichtung 1, 3 eine Übertragungseinrichtung 2, 4 auf. Das Teilnehmer-Endgerät UT weist eine Empfangseinrichtung RU (Receive Unit) und eine Einrichtung DPU (Data Processing Unit) zur Rekonstruktion von Datenblocks aus den empfangenen Daten auf.

Es seien nun als Beispiel für Datenblocks folgende Beispiele betrachtet:

- Nutzdaten N mit einer Länge von 96 Dateneinheiten bzw. Symbolen B1, B2, B3, B4....., B96, die Daten enthalten, aufgrund derer ein Endgerät UT unmittelbar seine Position bestimmen kann,

- Signalisierungsdaten A mit einer Länge von 12 oder 24 Dateneinheiten bzw. Symbolen A1, A2, A3, ... A12 bzw. A1, A2, A3, ... A24

- Signalisierungsdaten B mit einer Länge von 12 oder 24 Dateneinheiten bzw. Symbolen B1, B2, B3, ..., B12 bzw. B1, B2, B3, ..., B24

Statt Signalisierungsdaten können natürlich auch andere geeignete Arten von zeitkritischen Statusnachrichten vorgesehen werden.

Die Übertragung von Signalisierungsdaten in Datenübertragungssystemen ist oft deutlich zeitkritischer als die Übertragung von Nutzdaten. Außerdem sind die Signalisierungsdaten oft deutlich kürzer als die Nutzdaten.

Jede der drei Nachrichten N, A, B bildet einen Datenblock. Die einzelnen Dateneinheiten der Datenblocks werden durch die Einrichtung DIU zum Interleaving auf Pakete a, b, c, ... der Länge l=12 aufgeteilt, wie die Tabellen 1 und 2 veranschaulichen. Die Pakete a, b, c, ... sind hier in Form von Spalten dargestellt. Das Interleaving erfolgt durch eine Übertragung der Dateneinheiten in Zeilenrichtung der Tabelle 1 bzw. der Tabelle 2. Es wird also ein Interleaving realisiert, indem zunächst nacheinander alle Dateneinheiten übertragen werden, deren Datenadresse den niedrigsten Index aufweist, also a0, b0, c0, d0, ... Danach erfolgt die Übertragung der nächsten Reihe a1, b1, c1, d1, ... und so weiter bis zur Übertragung der letzten Reihe a11, b11, c11, d11, .... Wie man leicht erkennt, werden dadurch die einzelnen Dateneinheiten der einzelnen Datenblocks voneinander separiert übertragen. In den Tabellen 1 und 2 beträgt die Separierung m=8 Dateneinheiten für die Daten der Signalisierungsdaten.

Wie man ebenfalls aus den Tabellen 1 und 2 erkennt, werden nicht alle Pakete gleichermaßen mit Daten beliebiger Datenblocks gefüllt. Ein Teil der Pakete, nämlich im Fall der Tabelle 1 die Pakete c, f, i, l und im Fall der Tabelle 2 die Pakete c, h, sind für Daten der Signalisierungsdaten A, B reserviert, die übrigen Pakete sind für Nutzdaten N reserviert. Die Zahl der für Signalisierungsdaten reservierten Pakete wird über das Verhältnis der Datenmenge der Signalisierungsdaten zur Datenmenge der Nutzdaten definiert.

Besitzen die Nachrichten A, B eine Länge von 12 Dateneinheiten, so ist das Verhältnis 2*12 : 96 = 1 : 4 d.h. dass das Verhältnis

Zahl der Pakete für Signalisierungsdaten/Zahl der Pakete für'Nutzdaten

ebenfalls gleich 1 : 4 gewählt wird, wie Tabelle 2 zeigt.

Besitzen die Nachrichten A, B eine Länge von 24 Dateneinheiten, so ist das Verhältnis 2*24 : 96 = 1 : 2 d.h. dass das Verhältnis

Zahl der Pakete für SIgnallsierungsdaten/Zahl der Pakete für Nutzdaten

ebenfalls gleich 1 : 2 gewählt wird, wie Tabelle 1 zeigt.

Die Pakete, die für die Nutzdaten reserviert sind, werden fortlaufend mit Dateneinheiten N1, N2, N3, .... der Nutzdaten N aufgefüllt. Ist ein Paket a komplett gefüllt, so wird mit dem nächsten Paket b weitergemacht, bis alle Pakete, die für die Nutzdaten N reserviert sind, mit Nutzdaten N gefüllt sind.

Die Pakete, die für die Signalisierungsdaten A, B reserviert sind, werden jedoch anders gefüllt: Jedes Paket wird nur mit n/k Dateneinheiten gefüllt, wobei n die Länge des Pakets und k eine ganze Zahl k=2, 3, 4 darstellt. Insbesondere kann k die Zahl der im Rahmen der aktuellen Pakete zu übertragenden Signalisierungsdaten darstellen, hier also k=2. Folglich wird jedes entsprechend reservierte Paket nur mit 12/2 = 6 Dateneinheiten einer Integritätsnachricht, beginnend vom Anfang c0 des Pakets c, aufgefüllt. Sind die reservierten Pakete mit den Signalisierungsdaten A zur Hälfte gefüllt, dann wird die verbleibende Hälfte mit den Signalisierungsdaten B gefüllt, beginnend bei Datenadresse c6.

Anschließend erfolgt für die Datenübertragung ein Interleaving über alle Pakete a, b, c, d, ... wie bereits oben beschrieben. Ein Vorteil des hier beschriebenen Verfahrens ist, dass die Signalisierungsdaten A bereits nach der Hälfte der Zeit komplett vom Endgerät UT empfangen werden kann, die benötigt wird, um alle Pakete a, b, c... komplett zu übertragen. Dies wird durch die hier beschriebene Aufteilung der Signalisierungsdaten auf die Pakete und die anschließende zeilenweise Übertragung der Pakete möglich, da bereits nach Übertragung der ersten sechs Zeilen mit den Indizes 0, 1, 2, 3, 4, 5 die Signalisierungsdaten komplett übertragen sind. Damit wird garantiert, dass gerade zeitkritische Daten so schnell wie möglich zum Endgerät UT übertragen werden und trotzdem ein Interleaving mit ausreichender Separierung erfolgt.

Tabelle 1 für $m = 8$, $n = 12$, $k = 2$ and $l = 24$:

| | a | b | C | d | e | f | g | h | i | j | k | l |
|---|---|---|---|---|---|---|---|---|---|---|---|---|
| 11 | N12 | N24 | B6 | N36 | N48 | B12 | N60 | N72 | B18 | N84 | N96 | B24 |
| 10 | N11 | N23 | B5 | N35 | N47 | B11 | N59 | N71 | B17 | N83 | N95 | B23 |
| 9 | N10 | N22 | B4 | N34 | N46 | B10 | N58 | N70 | B16 | N82 | N94 | B22 |
| 8 | N9 | N21 | B3 | N33 | N45 | B9 | N57 | N69 | B15 | N81 | N93 | B21 |
| 7 | N8 | N20 | B2 | N32 | N44 | B8 | N56 | N68 | B14 | N80 | N92 | B20 |
| 6 | N7 | N19 | B1 | N31 | N43 | B7 | N55 | N67 | B13 | N79 | N91 | B19 |
| 5 | N6 | N18 | A6 | N30 | N42 | A12 | N54 | N66 | A18 | N78 | N90 | A24 |
| 4 | N5 | N17 | A5 | N29 | N41 | A11 | N53 | N65 | A17 | N77 | N89 | A23 |
| 3 | N4 | N16 | A4 | N28 | N40 | A10 | N52 | N64 | A16 | N76 | N88 | A22 |
| 2 | N3 | N15 | A3 | N27 | N39 | A9 | N51 | N63 | A15 | N75 | N87 | A21 |
| 1 | N2 | N14 | A2 | N26 | N38 | A8 | N50 | N62 | A14 | N74 | N86 | A20 |
| 0 | N1 | N13 | A1 | N25 | N37 | A7 | N49 | N61 | A13 | N73 | N85 | A19 |

Tabelle 2 für $m=8$, $n=12$, $k=2$ and $l=12$:

|  | a | b | c | d | e | f | g | h | i | j |
|---|---|---|---|---|---|---|---|---|---|---|
| 11 | N12 | N24 | B6 | N36 | N48 | N60 | N72 | B12 | N84 | N96 |
| 10 | N11 | N23 | B5 | N35 | N47 | N59 | N71 | B11 | N83 | N95 |
| 9 | N10 | N22 | B4 | N34 | N46 | N58 | N70 | B10 | N82 | N94 |
| 8 | N9 | N21 | B3 | N33 | N45 | N57 | N69 | B9 | N81 | N93 |
| 7 | N8 | N20 | B2 | N32 | N44 | N56 | N68 | B8 | N80 | N92 |
| 6 | N7 | N19 | B1 | N31 | N43 | N55 | N67 | B7 | N79 | N91 |
| 5 | N6 | N18 | A6 | N30 | N42 | N54 | N66 | A12 | N78 | N90 |
| 4 | N5 | N17 | A5 | N29 | N41 | N53 | N65 | A11 | N77 | N89 |
| 3 | N4 | N16 | A4 | N28 | N40 | N52 | N64 | A10 | N76 | N88 |
| 2 | N3 | N15 | A3 | N27 | N39 | N51 | N63 | A9 | N75 | N87 |
| 1 | N2 | N14 | A2 | N26 | N38 | N50 | N62 | A8 | N74 | N86 |
| 0 | N1 | N13 | A1 | N25 | N37 | N49 | N61 | A7 | N73 | N85 |

Diese spezielle Klasse von Beispielen kann in allgemeiner Form wie folgt dargestellt werden: Angenommen, es sollen Nutzdaten, also eine lange Datennachricht mit einer Länge von $n \times m$ Dateneinheiten bzw. Symbolen einmal pro Sekunde übertragen werden und es sollen $k$ Signalisierungsdaten, also kurze Nachrichten, mit einer Länge von $l$ Dateneinheiten bzw. Symbolen pro Sekunde übertragen werden Wenn man ganze Zahlen $i$, $j$ und $p$ finden kann, so dass gilt: $k \times l = i \times n$, $k \times j = n$ und $m = i \times (p-1)$, dann kann in jedem Fall eine Aufteilung der Daten auf Pakete erfolgen, wie sie beispielhaft in den Tabellen 1 und 2 gezeigt wurde.

Es kann dann ein Interleaving der Matrix erfolgen, die durch die Pakete gebildet wird und die

$$\left( \frac{k \times l}{n} + m \right)$$

spalten und $n$ Zeilen besitzt, wobei jede $\frac{m \times n}{k \times l}$-te Spalte für Signalisierungsdaten, also für kurze Nachrichten reserviert ist.

Die $m$ Spalten bzw. Pakete, die für die Nutzdaten (also für die lange Nachricht) reserviert sind, werden Spalte für Spalte und damit Paket für Paket mit Daten gefüllt. Dagegen wird beim Auffüllen der für Signalisierungsdaten (also für kurze Nachrichten) reservierten Spalten bzw. Paktete nach jedem $\frac{n}{k}$-ten Symbol die Spalte gewechselt wird. Es wird dann Zeile für Zeile der Matrix an die Endgeräte UT übertragen, wodurch die Gesamtheit der Daten gesendet wird und gleichzeitig ein Interleaving erfolgt.

Damit ergibt sich folgendes:

1. Eine lange Nachricht kann im Endgerät UT komplett de-interleaved werden, nachdem $k \times l + m \times n$ Symbole empfangen wurden.

2. Eine kurze Nachricht kann jedoch bereits komplett de-interleaved werden, nachdem $l + \frac{m \times n}{k}$ Symbole vom Endgerät empfangen wurden.

3. Die Separierung aufeinanderfolgender Symbole der kurzen Nachricht beträgt min

$$\left(\frac{k \times l}{n} + m, \frac{n}{k} + \frac{m \times n}{k \times l}\right)$$

Symbole.

4. Die Separierung aufeinanderfolgender Symbole der langen Nachricht beträgt n Symbole.

Ein Vorteil dieses Verfahrens ist damit, dass die kurzen Nachrichten $k$ Mal pro Sekunde komplett de-interleaved werden können und trotzdem eine ausreichende Separierung zwischen aufeinanderfolgenden Symbolen der kurzen Nachrichten gegeben ist. Sofern keine ganzen Zahlen $i$, $j$ und $p$ gefunden werden können, für die $k \times l = i \times n$, $k \times j = n$ und $m = i \times (p$-1$)$ gilt, kann grundsätzlich das gleiche Verfahren wie oben durchgeführt werden, aber dann werden

$$\left(\mathrm{int}\left(\frac{k \times l}{n}\right) + 1 + m\right)$$

Spalten bzw. Pakete benötigt, wenn weiterhin eine möglichst gleichmäßige und ausreichende Separierung zwischen aufeinanderfolgenden Symbolen der kurzen Nachrichten gegeben sein soll. Es kann dann auch vorgesehen werden, dass einzelne Datenadressen der Pakete bzw. Spalten mit Füll-Dateneinheiten wie Füllbits aufgefüllt werden, um wieder eine komplette Füllung einer ganzen Matrix mit Daten analog zu den Tabellen 1 und 2 zu erzielen und so Abweichungen der Länge der Nachrichten von der gewünschten Länge analog Tabellen 1 und 2 auszugleichen.

Betrachtet man nun noch das Teilnehmer-Endgerät UT, so kann dieses insbesondere mit Hilfe eines Computer-Programms zur Verarbeitung der empfangenen Daten zur Rekonstruktion der Datenblocks des Datenübertragungssystems eingerichtet werden, wenn die sonstigen Hardware-Voraussetzungen in dem Teilnehmer-Endgerät UT gegeben sind. Das Computer-Programm ermöglicht dann insbesondere im Zusammenwirken mit der Datenverarbeitungseinrichtung DPU das Erkennen und Verarbeiten der Datenpakete von Signalisierungsdaten A, B und von Nutzdaten N. Mit Hilfe des Computer-Programms können aus den empfangenen Daten, die ein Interleaving durchlaufen haben, durch ein komplementäres De-Interleaving die ursprünglichen Signalisierungsdaten A, B und Nutzdaten N wieder hergestellt werden.

Das Computer-Programm kann bevorzugt mit Hilfe eines Computer-Programm-Produktes in das Teilnehmer-Endgerät UT eingebracht werden, wobei das Computer-Programm-Produkt einen maschinenlesbaren Programmträger (Data Carrier) DC beinhaltet, auf dem das Computer-Programm in Form von elektronisch auslesbaren Steuersignalen gespeichert ist. Ein Beispiel wäre eine Chipkarte mit einem Halbleiterchip, in dem das Computerprogramm gespeichert ist. Es sind aber auch alle anderen geeigneten Arten von Computer-Programm-Produkten anwendbar.

**Patentansprüche**

1. Verfahren zur Bereitstellung und Übertragung von Daten in einem Datenübertragungssystem durch Übertragung von mehreren Datenblocks von einer Daten-Sendeeinrichtung an Endgeräte, wobei vor der Übertragung der Daten an die Endgeräte ein Interleaving von mindestens zwei Datenblocks erfolgt, **dadurch gekennzeichnet, dass** zum Interleaving für jede Dateneinheit der Datenblocks mit Hilfe eines Algorithmus ein Sendezeitpunkt derart festgelegt wird, dass zur Übertragung von k zeitkritischen Datenblocks mit k= 2, 3, 4, ... und eines zeitunkritischen Datenblocks die Sendezeitpunkte der Dateneinheiten eines jeden zeitkritischen Datenblocks jeweils in einem Bruchteil 1/k der Sendezeit des zeitunkritischen Datenblocks festgelegt werden.

2. Verfahren nach Anspruch 1, **dadurch gekennzeichnet, dass** die Datenblocks in gleiche Pakete mit indizierten Datenadressen aufgeteilt werden und ein Interleaving durch aufeinanderfolgende Übertragung jeweils einer Dateneinheit eines Paketes erfolgt.

3. Verfahren nach Anspruch 2, **dadurch gekennzeichnet, dass** zunächst nacheinander die Dateneinheiten aller Pakete mit der niedrigsten oder höchsten Datenadresse gesendet werden und dann die nacheinander die Dateneinheiten aller Pakete mit der nächsthöheren oder nächstniedrigeren Datenadresse gesendet werden.

4. Verfahren nach Anspruch 2 oder 3, **dadurch gekennzeichnet, dass** mindestens eine erste Gruppe von Paketen für Datenblocks mit zeitkritischen Daten reserviert wird und mindestens eine zweite Gruppe von Paketen für Datenblocks mit zeitunkritischen Daten reserviert wird.

5. Verfahren nach einem der Ansprüche 1 bis 4, **dadurch gekennzeichnet, dass** als zeitkritische Daten Statusnachrichten oder Signalisierungsdaten übertragen werden und als zeitunkritische Daten Nutzdaten übertragen werden.

6. Verfahren nach einem der Ansprüche 2 bis 5, **dadurch gekennzeichnet, dass**

   - alle Pakete eine Länge von n Dateneinheiten aufweisen,
   - Pakete der ersten Gruppe von Paketen mit n/k, k=2, 3, 4, 5... Dateneinheiten eines Datenblocks zeitkritischer Daten gefüllt werden und
   - Pakete der zweiten Gruppe von Paketen mit n Dateneinheiten eines Datenblocks zeitunkritischer Daten gefüllt werden.

7. Verfahren nach einem der Ansprüche 1 bis 6, **dadurch gekennzeichnet, dass** die Datenmenge der zeitkritischen Daten maximal die Hälfte der Datenmenge der zeitunkritischen Daten beträgt.

8. Verfahren nach Anspruch 7, **dadurch gekennzeichnet, dass** die Datenmenge der zeitkritischen Daten maximal ein Viertel der Datenmenge der zeitunkritischen Daten beträgt.

9. Teilnehmer-Endgerät (UT) für ein Datenübertragungssystem zum Empfang und De-Interleaving von Daten, welche vor dem Empfang einem Verfahren nach einem der Ansprüche 1 bis 8 unterzogen wurden, aufweisend eine Einrichtung (DPU) zur Rekonstruktion von Datenblocks, welche vom Teilnehmer-Endgerät durch eine Empfangseinrichtung (RU) von mindestens einer Daten-Sendeeinrichtung (1, 3) empfangen wurden, und ausgebildet zum De-Interleaving von Daten einer Form, welche sich durch ein Interleaving nach einem Verfahren nach einem der Ansprüche 1 bis 8 ergibt.

10. Teilnehmer-Endgerät nach Anspruch 9, eingerichtet zur Verarbeitung von Daten eines Datenübertragungssystems mit Hilfe eines Computer-Programms, wobei die Daten des Datenübertragungssystems nach einem Verfahren nach einem der Ansprüche 1 bis 8 einem Interleaving unterzogen wurden und wobei das Computer-Programm für ein Zusammenwirken mit Einrichtungen (DPU) des Teilnehmer-Endgerätes (UT) ausgebildet ist.

11. Teilnehmer-Endgerät nach Anspruch 10, eingerichtet zur Aufnahme eines Computer-Programm-Produkts beinhaltend einen maschinenlesbaren Programmträger (DC), auf dem ein Computer-Programm nach Anspruch 10 in Form von elektronisch auslesbaren Steuersignalen gespeichert ist, wobei das Computer-Programm-Produkt zum Zusammenwirken mit dem Teilnehmer-Endgerät (UT) ausgebildet ist.

Fig. 1